## Europäisches Patentamt
## European Patent Office
## Office européen des brevets

(19)

(11) Veröffentlichungsnummer: **0 051 693**
**B1**

(12) # EUROPÄISCHE PATENTSCHRIFT

(45) Veröffentlichungstag der Patentschrift:
**19.06.85**

(51) Int. Cl.⁴: **H 03 K 19/177, G 11 C 17/00**

(21) Anmeldenummer: **80106964.2**

(22) Anmeldetag: **12.11.80**

(54) **Elektrisch umschaltbarer Festwertspeicher.**

(43) Veröffentlichungstag der Anmeldung:
**19.05.82 Patentblatt 82/20**

(45) Bekanntmachung des Hinweises auf die Patenterteilung:
**19.06.85 Patentblatt 85/25**

(84) Benannte Vertragsstaaten:
**DE FR GB IT NL SE**

(56) Entgegenhaltungen:
**US - A - 4 177 452**

**IBM TECHNICAL DISCLOSURE BULLETIN, Band 22, Nr. 10, März 1980, Seiten 4621, 4622 New York, U.S.A. D.G. GRICE et al.: "Electrically programmable logic array"**
**IBM TECHNICAL DISCLOSURE BULLETIN, Band 20, Nr. 10, März 1978, Seiten 4016-4018 New York, U.S.A. P.S. BALASUBRAMANIAN et al.: "Increasing chip density by space sharing of programmed logic arrays"**

(73) Patentinhaber: **IBM DEUTSCHLAND GMBH, Pascalstrasse 100, D-7000 Stuttgart 80 (DE)**

(84) Benannte Vertragsstaaten: **DE**

(73) Patentinhaber: **International Business Machines Corporation, Old Orchard Road, Armonk, N.Y. 10504 (US)**

(84) Benannte Vertragsstaaten: **FR GB IT NL SE**

(72) Erfinder: **Götze, Volkmar, Malteserstrasse 69, D-7031 Grafenau 2 (DE)**
Erfinder: **Miersch, Ekkehard, Dr., Narzissenstrasse 8, D-7030 Böblingen (DE)**
Erfinder: **Potz, Günther, Amselweg 21, D-7032 Sindelfingen (DE)**

(74) Vertreter: **Mönig, Anton, Dipl.-Ing., Schönaicher Strasse 220, D-7030 Böblingen (DE)**

## Beschreibung

Die Erfindung bezieht sich auf elektrisch umschaltbare Festwertspeicher der im Oberbegriff des Patentanspruchs 1 angegebenen Art. Derartige Festwertspeicher werden in der Computertechnik in zunehmendem Maße eingesetzt, um feste Daten permanent, d. h. nicht-flüchtig zu speichern. Sowohl in technologischer Hinsicht als auch im Hinblick auf ihre Einordnung in die Gesamtkonzeption des jeweiligen Rechneraufbaus sind vielfältige Formen solcher Festwertspeicher bekannt. In diesem Zusammenhang werden als zunehmend interessanter werdende Ausführungsformen von Festspeichermatrizen die sog. PLAs (Programmable Logic Arrays) genannt, für die sich eine allgemeine Darstellung in dem Buch MOS/LSI Design and Application von W. Carr und J. Mize, McGraw-Hill 1972, Seiten 229 bis 258 findet.

Zusammengefaßt erlauben solche aus ROMs (UND-/ODER-Felder) zusammengesetzte PLAs die direkte Implementierung (minimierter) kombinatorischer Logik in regelmäßigen Matrixanordnungen. Gegenüber dem Aufbau logischer Verknüpfungssysteme in ungeordneter Art bieten derartige als einseitige Zuordner benutzte Festwertspeicher, ROMs wie PLAs, vielfältige Vorteile, die sie zunehmend attraktiv als Ersatz für kombinatorische Logik, als Speicher für Tabellen, Konstanten und Programme, zur Code-Generierung und -Konvertierung, als fest verdrahtete Multiplizierer und anderes mehr machen.

Im allgemeinen erfolgt bei Festwertspeichern und daraus zusammengesetzten PLAs die Einprägung der jeweiligen Funktion(en) im Rahmen der Herstellung und liegt dann ein für allemal fest. Um die damit verbundene Einschränkung auszuräumen, wurden auch bereits verschiedene Wege beschritten, um eine Änderungsmöglichkeit vorzusehen. Daraus resultierten einmal sog. umprogrammierbare Festwertspeicher, vgl. z. B. US-PS 4 041 459, deren Änderungsmöglichkeit jedoch mit anderen Nachteilen erkauft wird. Als Koppelelemente bzw. Speicherzellen sind nämlich beispielsweise gegenüber MOS-Feldeffekttransistoren (FET) technologisch erheblich aufwendigere MI₁I₂S-FET, d. h. FET mit Doppelschicht-Gaste-Dielektrikum, erforderlich. Zudem erfordert die Umprogrammierung relativ hohe Spannungsimpulse von größenordnungsmäßig 30 V. Letzten Endes sind derartige umprogrammierbare Festwertspeicher im Hinblick auf die Änderungsmöglichkeit für viele Anwendungen erheblich zu langsam.

Zum anderen wurden aber auch bereits Festwertspeicher mit Änderungsmöglichkeit beschrieben, die eine demgegenüber schnellere elektrische Umschaltbarkeit bieten sollten. So ist in der US-PS 3 987 286 eine Anordnung beschrieben, bei der durch zeitlich versetztes Freigeben oder Sperren von Verknüpfungsgliedern der Matrixanordnungen unterschiedliche logische Funktionen in ein und demselben PLA durchgeführt werden können. Die entsprechende Beeinflussung der Koppelelemente erfolgt dabei über in zusätzlich erforderlichen Schieberegisterelementen gespeicherte Daten. Weiterhin ist eine Form der Mehrfachpersonalisierung mit besonderen Koppel- oder Verknüpfungselementen bekannt, die z. B. vier mögliche Zustände einnehmen können, vgl. IBM TDB Vol. 17, No. 3, August 1974, Seiten 811/812. Diese Lösungen sind wegen der benötigten Sonderbauelemente bzw. wegen ihrer relativen Langsamkeit weiterhin verbesserungsbedürftig.

Eine weitere bekanntgewordene Gruppe derartiger Festwertspeicher und insbesondere PLAs hat sich zum Ziel gesetzt, verbleibende ungenutzte Verknüpfungsbereiche für weitere Funktionen auszunutzen, vgl. z. B. IBM TDB Vol. 20, No. 10, März 1978, Seiten 4016 bis 4018 oder mittels Time-Sharing-Maßnahmen solche Bereiche mehrfach zu nutzen, vgl. US-PS 4 084 152. Derartige Maßnahmen bedeuten jedoch erhebliche Einschränkungen hinsichtlich des Freiheitsgrades, den der mit der Auslegung komplexer Verknüpfungsnetzwerke befaßte Fachmann hat. Der an sich mit derartigen regelmäßigen Strukturen erwünschte hohe Grad an Flexibilität und leichter Anpaßmöglichkeit geht dabei weitgehend verloren.

Schließlich sind im Zusammenhang mit dem Aufbau von elektrisch änderbaren Permanentspeichern auch bereits Speicher beschrieben worden, deren Zellen je aus einem MNOS-Transistor bzw. einem Transistor mit »freischwebenden« Gate in Serie mit je einem zugeordneten Trenntransistor vom normalen MOS-Typ bestehen, vgl. DE-OS 2 844 955 und DE-OS 2 937 337. Ein schnelles Umschalten zwischen mehreren Funktionen ist damit ebensowenig möglich wie bei den oben bereits genannten Speichern mit elektrischer Umprogrammierungsmöglichkeit, zu welcher Gruppe auch diese Speicher gehören. Sie werden hier lediglich im Hinblick auf eine gewisse Ähnlichkeit der jeweiligen Halbleiterausbildung angeführt.

Die Erfindung, wie sie in den Patentansprüchen gekennzeichnet ist, löst die Aufgabe, eine weitere Verbesserung derartiger Festspeicher, wie sie für PLAs einsetzbar sind, im Sinne höherer Funktionsdichten anzugeben, die insbesondere eine schnelle elektrische Umschaltung zwischen unterschiedlichen Funktionen erlauben und keine hohen Umprogrammierungsspannungen oder Sonderbauelemente erfordern.

Die mit der Erfindung erzielbaren Vorteile sind insbesondere darin zu sehen, daß damit hochintegrierte und schnell umschaltbare Festspeicher- bzw. PLA-Funktionen unter Ausnutzung einer nur einmal vorzusehenden Peripherie zur Verfügung stehen, womit z. B. hochdichte Prozessor-Chips mit integrierten PLA-Funktionen in einer systemmäßigen Doppelarchitektur aufgebaut werden können.

Im folgenden wird die Erfindung anhand von lediglich einen Ausführungsweg darstellenden Zeichnungen näher erläutert.

Es zeigt

Fig. 1 eine schematische Personalisierungsanweisung für eine erste PLA-Funktion;

Fig. 2 eine schematische Personalisierungsanweisung für eine zweite PLA-Funktion;

Fig. 3 die schematische Personalisierungsanweisung für die Zusammenfassung beider vorgenannten PLA-Funktionen in einem PLA;

Fig. 4 ein teilweise schematisches elektrisches Schaltbild für die Durchführung beider PLA-Funktionen gemäß der Erfindung;

Fig. 5 eine schematische Draufsicht auf eine bevorzugte integrierte Ausführungsform eines Teils der in Fig. 4 gezeigten Schaltung und

Fig. 6 eine Querschnittsdarstellung entlang der Schnittlinie 6-6 in Fig. 5 zur Erläuterung des schematischen vertikalen Aufbaus der bevorzugten integrierten Ausführungsform.

Als Beispiel zur Erläuterung der Erfindung ist ein 2fach personalisierbares PLA gewählt. Das PLA soll zwei Funktionszustände F1 und F2 mit unterschiedlichen Verknüpfungsfunktionen X und Y der Eingänge A, B, C und D bieten, zwischen denen eine schnelle elektrische Umschaltung möglich sein soll. In den unterschiedlichen PLA-Funktionszuständen sollen beispielsweise die Verknüpfungen folgendermaßen lauten:

$$F1: \quad X = \bar{A} \cdot \bar{B} \cdot \bar{C} + \bar{D}$$
$$Y = \bar{A} \cdot \bar{B} \cdot \bar{C}$$

$$F2 \quad X = \bar{A} \cdot \bar{B} \cdot \bar{D} + \bar{A} \cdot \bar{C}$$
$$Y = \bar{A} \cdot \bar{C}$$

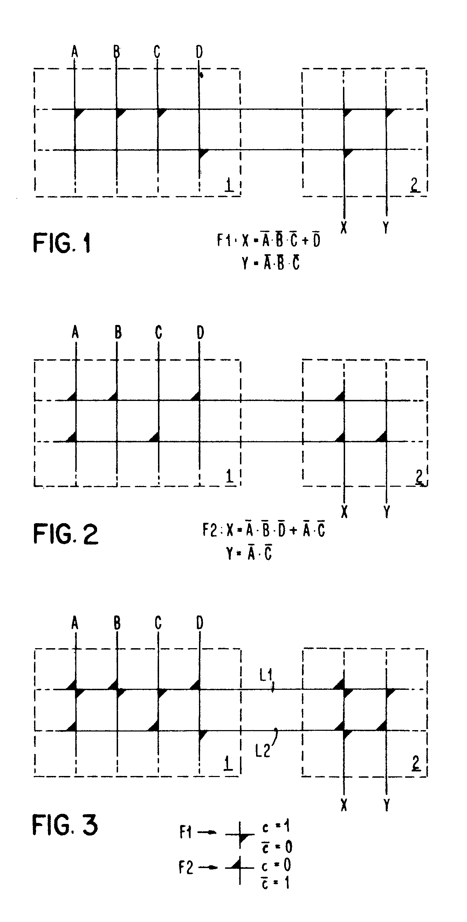

In den Fig. 1 und 2 ist die jeweils zugehörige Personalisierung zweier 1fach personalisierbarer PLA in üblicher schematischer Darstellung illustriert. Ob einer der Eingänge A, B, C, D in die Verknüpfung mit eingeht, ist durch Markierungen an den betreffenden Matrix-Kreuzungsstellen angezeigt. Fig. 3 zeigt schließlich entsprechend dem Ziel, das mit vorliegender Erfindung verfolgt wird, die zusammengefaßte Darstellung beider Personalisierungen in einem einzigen PLA, das eine Umschaltung zwischen den Funktionszuständen F1 und F2 erlauben soll. Welcher der beiden Funktionszustände F1, F2 ausgewählt ist, hängt ab vom Potentialzustand (log. »0« oder »1«) eines entsprechend vorzusehenden Paares von Steuerleitungen c und c̄. Darauf wird bei der späteren Beschreibung des Ausführungsbeispiels noch näher eingegangen werden.

Für die Funktionszustände F1 und F2 sind im vorliegenden Fall folgende Zustände der Steuerleitungen c und c̄ vereinbart (Fig. 3):

$$F1: \quad c = 1 \text{ und } \bar{c} = 0$$
$$F2: \quad c = 0 \text{ und } \bar{c} = 1$$

In den Fign. 1 bis 3 deuten schließlich die Bezugszeichen 1 und 2 das jeweils aus einer ROM-Matrix bestehende UND-Feld 1 und das ODER-Feld 2 an, aus denen sich bekanntlich PLAs zusammensetzen.

Das in Fig. 3 schematisch dargestellte Personalisierungsmuster faßt somit die in den Fig. 1 und 2 gezeigten Funktionen zusammen. Es läßt sich als Überlagerung der einzelnen Personalisierungsmuster für F1 (Fig. 1) und F2 (Fig. 2) verstehen.

Mit den Maßnahmen nach der Erfindung kann nun ein derartiges PLA sehr flächensparend ausgelegt werden. Die neuartigen hochintregierbaren Koppelelemente mit ihren Personalisierungsmöglichkeiten erlauben es, PLAs mit mindestens zwei unabhängig voneinander wählbaren, fest eingeprägten Verknüpfungsfunktionen unter Benutzung ein und derselben Peripherie nahezu mit einem Platzaufwand zu realisieren, wie er bisher für nur eine Funktion benötigt wurde. Damit erschließen sich in einem Systemzusammenhang eine ganze Reihe neuer Einsatzgebiete für solche Festspeicher.

Wie aus Fig. 3 hervorgeht, müssen im Falle eines 2fach personalisierbaren PLA die Koppelelemente und deren »Verdrahtung« mindestens vier unterscheidbare Personalisierungsmöglichkeiten gestatten. So soll für das gewählte Ausführungsbeispiel im UND-Feld 1 das Koppelelement zwischen der Eingangsleitung für A und der mit L1 bezeichneten Produktterm- oder Reihenleitung, also an der Kreuzungsstelle A/L1, in beiden Funktionszuständen F1 und F2 eine Verbindung bereitstellen. Das Koppelelement bei C/L1 bewirkt dagegen nur in Funktionszustand F1 und das Koppelelement bei A/L2 nur im Funktionszustand F2 eine entsprechende Verbindung. Schließlich ist an der Kreuzungsstelle B/L2 in keinem Fall eine Verbindung vorgesehen; der Eingang B wird somit im Hinblick auf die sog. Produkttermbildung auf der Leitung L2 ignoriert. Ein solcher möglicher Personalisierungszustand wird üblicherweise bei einem PLA als »Don't care«-Position bezeichnet.

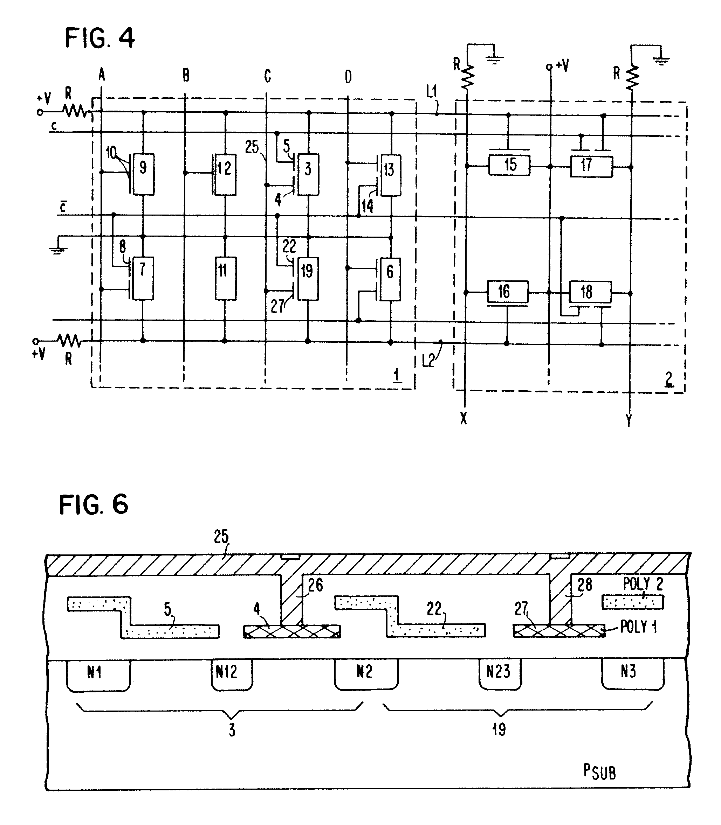

Fig. 4 zeigt ein Ausführungsbeispiel der Erfindung, mit dem die in Fig. 3 markierten PLA-Funktionen realisiert sind. Charakteristisch für die Erfindung ist die Art der Koppelelemente oder Zellen und die mit diesen Koppelelementen durchführbaren Personalisierungszustände, auf die oben eingegangen ist. Die Koppelelemente sind dabei als FET ausgeführt, für die mindestens zwei Gate-Abschnitte nebeneinander vorgesehen sind. Zum Leitendwerden der zugehörigen Schaltstrecke eines solchen Koppelelements ist es erforderlich, daß an allen im vorliegenden Beispiel den beiden Gate-Abschnitten die zugehörigen Einschaltpotentiale vorliegen. Die mindestens zwei umschaltbaren Verknüpfungsfunktionen F1 und F2 werden strukturmäßig in der Weise eingeprägt, daß bei einer nur im Rahmen einer der beiden Funktionen herzustellenden Verbindung einer der Gate-Abschnitte mit der für diese Funktionsauswahl maßgeblichen Steuerleitung und der verbleibende Gate-Abschnitt eines solchen Koppelelementes mit der betreffenden Eingangsleitung verbunden wird. Soll im Rahmen beider Funktionen an der betreffenden Kreuzungsstelle eine Verbindung wirksam werden, werden beide Gate-Abschnitte und damit das komplette Gate gemeinsam an die betreffende Eingangsleitung angeschlossen. Eine »Don't care«-Position wird dadurch realisiert, daß man das betreffende Koppelelement nicht oder nicht vollständig ausbildet, so daß an dieser Kreuzungsstelle zu keinem Zeitpunkt eine Verbindung wirksam werden kann.

Im folgenden soll auf das in Fig. 4 als Ausführungsbeispiel gezeigte 2fach personalisierbare PLA näher eingegangen werden. Im Vergleich zu Fig. 3 erkennt man wiederum das mit 1 bezeichnete UND-Feld mit den Eingängen A, B, C und D sowie das mit 2 bezeichnete ODER-Feld mit den Ausgängen X und Y. Die Verbindung zwischen den Feldern 1 und 2 wird über die (Produktterm-)Leitungen L1, L2 sowie über die Steuerleitungen c, c̄ für die Festlegung des jeweiligen Funktionszustandes F1 oder F2 hergestellt. Für die als Koppelelemente verwendeten FET seien für das Ausführungsbeispiel N-Kanal MOSFETs vom Anreicherungstyp angenommen. Deren grundsätzliche Betriebscharakteristiken können als bekannt vorausgesetzt werden. Die in Fig. 4 gegebene Darstellung beschränkt sich ferner der Klarheit halber auf die für das Verständnis der logischen Verknüpfungsoperationen notwendigen peripheren Schaltungsteile, wie z. B. die Betriebsspannungszuführung über +V und die mit R bezeichneten Widerstände. Nicht gezeigt sind die diversen Ansteuerschaltungen oder allgemein Peripherie-Schaltkreise, wie etwa Eingangspuffer, Dekoder, Phasensplitter, Treiber etc., weil sich die Erfindung nicht darauf bezieht und die Peripherie-Schaltkreise konventionell ausgeführt werden können. Insoweit wird auf die eingangs genannte Literatur zum Stand der Technik verwiesen.

Schließlich sei im Rahmen dieses Ausführungsbeispiels für die diversen Eingangs-/Ausgangs- und Steuersignale die Vereinbarung einer »positiven Logik« vorausgesetzt. Danach entspreche dem logischen Zustand »1« der obere Pegel eines Binärsignals, hier etwa das Potential +V. Entsprechend werde der logische Zustand »0« durch den unteren Spannungspegel repräsentiert, hier etwa Massepotential.

Aus der gemeinsamen Betrachtung der Fig. 3 und 4 werden die Maßnahmen der Erfindung zur Realisierung des funktionsmäßig in Fig. 3 charakterisierten PLAs in einer konkreten Schaltungsanordnung deutlich. Die z. B. ausschließlich im Funktionszustand F1 vorzusehende Kopplung an der Kreuzungsstelle C/L1 im UND-Feld 1 wird durch den FET 3 mit den beiden Gate-Abschnitten 4 und 5 gebildet. Der Gate-Abschnitt 4 ist mit dem Eingang C und der Gate-Abschnitt 5 ist mit der Steuerleitung c verbunden. Damit wird der FET 3 nur leitend, wenn sowohl der zugehörige Eingang C als auch die Steuerleitung c den logischen »1«-Zustand aufweisen. Das ist vereinbarungsgemäß aber nur der Fall im Funktionszustand F1. Dieselbe Situation liegt beispielsweise auch für die Kreuzungsstelle D/L2 vor; das zugehörige Koppelelement ist in Fig. 4 der FET 6.

Als nächstes sei der Fall betrachtet, bei dem nur im Funktionszustand F2 eine Verbindung bestehen soll. Das ist z. B. der Fall an der Kreuzungsstelle A/L2 (oder auch C/L2, D/L1). Dieser Fall entspricht voll dem oben erläuterten Fall mit der einzigen Abweichung, daß der das Koppelelement darstellende FET 7 mit seinem Gate-Abschnitt 8 an die c̄-Steuerleitung angeschlossen ist. Der FET 7 wird somit nur leitend, wenn sowohl der zugehörige Eingang A als auch die Steuerleitung c̄ den logischen »1«-Zustand aufweisen. Das ist vereinbarungsgemäß nur im Funktionszustand F2 der Fall. Festzuhalten ist im übrigen, daß ein nur in einem der beiden Funktionszustände F1 oder F2 wirksames Koppelelement für den jeweils unwirksamen Funktionszustand F2 oder F1 eine sog. »Don't care«-Position darstellt, wie sie oben erläutert wurde.

Die feste Einprägung des Falles, daß ein Koppelelement in beiden Funktionszuständen F1, F2 wirksam sein soll, liegt z. B. an der Kreuzungsstelle A/L1 (und auch B/L1) vor. Diesem Personalisierungszustand entspricht in einfacher Weise ein mit seinem kompletten Gate an dem betreffenden Eingang liegender FET, z. B. FET 9 mit seinem Gate 10 an A. Je nachdem wie dieser Personalisierungszustand herstellungsmäßig in seiner Struktur festgelegt wird, kann das Gate 10 entweder gleich als komplettes Einfach-Gate oder auch durch Verbindung zweier getrennt vorsehbarer Gate-Abschnitte gebildet werden. Bezüglich der zur Verfügung stehenden alternativen Möglichkeiten zur Herstellung solcher Strukturpersonalisierungen kann auf die allgemein bei ROMs und PLAs bekannten Techniken verwiesen werden. Danach kann die jeweilige Personalisierungsmaßnahme beispielsweise bei den Dotierungs-, Maskierungs-, Metallisierungsschritten etc. im Rahmen der Schaltungsherstellung erfolgen.

Ein Beispiel für eine »Don't care«-Position, bei der der betreffende Eingang für beide Funktionszustände F1 und F2 ignoriert wird, ist die Kreuzungsstelle B/L2. An dieser Stelle ist in Fig. 4 ein FET 11 ohne Gate(s) dargestellt. Da im Ausführungsbeispiel Feldeffekttransistoren vom Anreicherungstyp, normalerweise nicht-leitend sind, vorausgesetzt worden sind, kommt an dieser Kreuzungsstelle zu keinem Zeitpunkt eine leitende Verbindung zustande. Natürlich läßt sich auch dieser Personalisierungszustand alternativ ausbilden, indem man eine (oder mehrere) andere Voraussetzung(en) für einen betriebsfähigen FET nicht erfüllt.

Für die im ODER-Feld 2 vorgesehenen vier Kreuzungsstellen sind Koppelelemente von derselben Art nach denselben »Verdrahtungsregeln« zur Personalisierung vorgesehen wie im eben behandelten UND-Feld 1. Hier sind lediglich statt externer Eingänge die mit L1, L2 bezeichneten Ausgangsleitungen des UND-Feldes 1 als Eingangsleitungen anzusehen. Die Ausgangsleitungen des ODER-Feldes 2 werden durch die Spaltenleitungen für die (Summen-)Terme X und Y gebildet.

Für die Erläuterung der Betriebsweise der in Fig. 4 gezeigten Schaltung wird zunächst der Funktionszustand F1 angenommen. Dafür gilt vereinbarungsgemäß $c = 1$ und $\bar{c} = 0$. Somit sind alle mit einem Gate-Abschnitt an die $\bar{c}$-Leitung angeschlossenen FET gesperrt. Für alle mit ihrem Gate-Abschnitt an die c-Leitung angeschlossenen FET ist aber bereits eine der (bei 2 Gates) beiden Bedingungen für ein Leitendwerden des betreffenden FET erfüllt. Die zweite Bedingung wird in diesen Fällen durch den Zustand (»0« oder »1«) des zugehörigen Eingangs gebildet. Wo — wie z. B. beim FET 9 — das komplette Gate 10 (oder beide Gate-Abschnitte) mit einem Eingang verbunden sind, fällt der jeweilige Funktionszustand als Bedingung weg; der Leitzustand vom FET 9 hängt damit nur vom Eingangszustand A ab. Bei den für Fig. 4 getroffenen Annahmen im Hinblick auf die Transistortypen, Signalpolaritäten etc. werden somit bei $c = 1$, d. h. positiven Potential an der c-Leitung, in der oberen Reihe des UND-Feldes 1, die FET 9, 12 und 3 leitend werden, wenn die zugehörigen Eingänge A, B oder C den logischen »1«-Zustand annehmen. In diesem Fall wird das Potential auf der mit L1 bezeichneten Leitung über den oder die leitenden FET in Richtung auf Massepotential abgesenkt. Mit anderen Worten bleibt L1 nur dann auf dem oberen Pegel (»1«), wenn alle FET in dieser Reihe gesperrt bleiben, d. h. A, B und C im »0«-Zustand sind. Der Eingang D am FET 13 wird ignoriert, da seine Gate-Hälfte 14 mit der $\bar{c}$-Leitung verbunden und FET 13 im Funktionszustand F1 dauernd gesperrt gehalten wird. Für L1 als einer logischen Ausgangsleitung des UND-Feldes 1 gilt somit:

$$L1 = \bar{A} \cdot \bar{B} \cdot \bar{C}$$

In gleicher Weise gilt für die untere Reihe im UND-Feld 1, daß die Ausgangsleitung L2 nur dann auf dem oberen Pegel (»1«) bleibt, wenn FET 6 als einziger an der c-Leitung angeschlossener FET gesperrt bleibt, d. h. dessen Eingang D im »0«-Zustand ist. Es gilt demnach: $L2 = \bar{D}$.

Weiter stellen nun L1 und L2 Eingangsleitungen für das mit 2 bezeichnete ODER-Feld dar. Von den vier darin vorgesehenen Koppelelementen sind im Funktionszustand F1 mit $c = 1$ und $\bar{c} = 0$ die FET 15, 16 und 17 bereit für den Leitzustand, wenn die zugehörigen Eingangsleitungen L1, L2 den oberen Pegel (»1«) aufweisen. Mit den oben für L1 und L2 geltenden logischen Beziehungen ergibt sich somit, daß die Ausgangsleitung X bereits dann den oberen Pegel ($+V$) bzw. den »1«-Zustand annimmt, wenn L1 oder L2 positiv ist (ODER-Funktion). Daraus folgt die logische Gleichung:

$$X = L1 + L2 = \bar{A} \cdot \bar{B} \cdot \bar{C} + \bar{D}$$
(vgl. Fig. 1)

Ist z. B. L1 positiv, wird die über R an Masse liegende X-Leitung über den leitenden FET 15 in Richtung auf die Betriebsspannung $+V$ angehoben. Gleiches gilt für positives Potential auf der L2-Leitung infolge des dann leitenden FET 16.

Für den Ausgang Y gilt, daß es allein vom Zustand des FET 17 und somit von L1 abhängt, ob die zugehörige Y-Leitung den oberen Pegel (»1«-Zustand) annehmen kann. Der weitere FET 18 ist wegen seiner Gateverbindung zur $\bar{c}$-Leitung im Funktionszustand F1 gesperrt. Es ergibt sich somit:

$$Y = L1 = \bar{A} \cdot \bar{B} \cdot \bar{C} \text{ (vgl. Fig. 1)}$$

Für die in Fig. 2 dargestellten Verknüpfungen während des Funktionszustandes F2 gilt die obige Beschreibung des Betriebsvorgangs entsprechend. Dabei ist lediglich die Umkehrung der logischen Zustände auf den Steuerleitungen c und $\bar{c}$ zu beachten. In diesem Fall sind alle mit der c-Leitung verbundenen FET wegen $c = 0$ unabhängig vom Signaleingang gesperrt, d. h. die FET 3, 6 und 17. Es gilt wiederum, daß L1 nur dann positiv bleibt, wenn die für ein Leitendwerden in Frage kommenden FET 9, 12 und 13 gesperrt bleiben, also ihre Eingänge A, B und D in »0«-Zustand bleiben, d. h.

$$L1 = \bar{A} \cdot \bar{B} \cdot \bar{D}.$$

Entsprechend kommt es für $L2 = 1$ darauf an, daß die FET 7 und 19 gesperrt bleiben, also ihre Eingänge A und C im »0«-Zustand bleiben, d. h.

$$L2 = \bar{A} \cdot \bar{C}.$$

Die weiteren FET 11 bzw. 6 können nicht leitend werden, da die Gates nicht angeschlossen sind bzw. ein Gate mit der c-Steuerleitung ($c = 0$) kontaktiert ist. Die ODER-Verknüpfung von L1 und L2 im ODER-Feld 2 erfolgt ebenfalls in entsprechender Weise, wie oben für F1 beschrieben. Statt zuvor FET 18 ist jetzt FET 17 gesperrt, so daß für den Ausgang Y der L1-Zustand ignoriert wird. Die insgesamt gebildeten Verknüpfungen sind demnach die in Fig. 2 dargestellten.

An dieser Stelle kann bereits festgehalten werden, daß auf die gezeigte Weise unter Vermeidung von Sonderbauelementen, wie z. B. MNOS-FET oder dgl., PLAs mit fest eingeprägter Mehrfach-Personalisierung zur Verfügung gestellt werden können, die eine außergewöhnlich schnelle Umschaltmöglichkeit zwischen den jeweils eingeprägten Funktionen durch einfaches Umschalten von Steuerleitungspotentialen (c, $\bar{c}$) bieten. Es ist ferner ersichtlich, daß diese Mehrfach-Personalisierung auch nicht etwa mit einem entsprechend mehrfachen Aufwand an zusätzlichen Koppelelementen und damit bei angestrebter intergrierter Ausbildung an Halbleiterfläche erkauft werden muß.

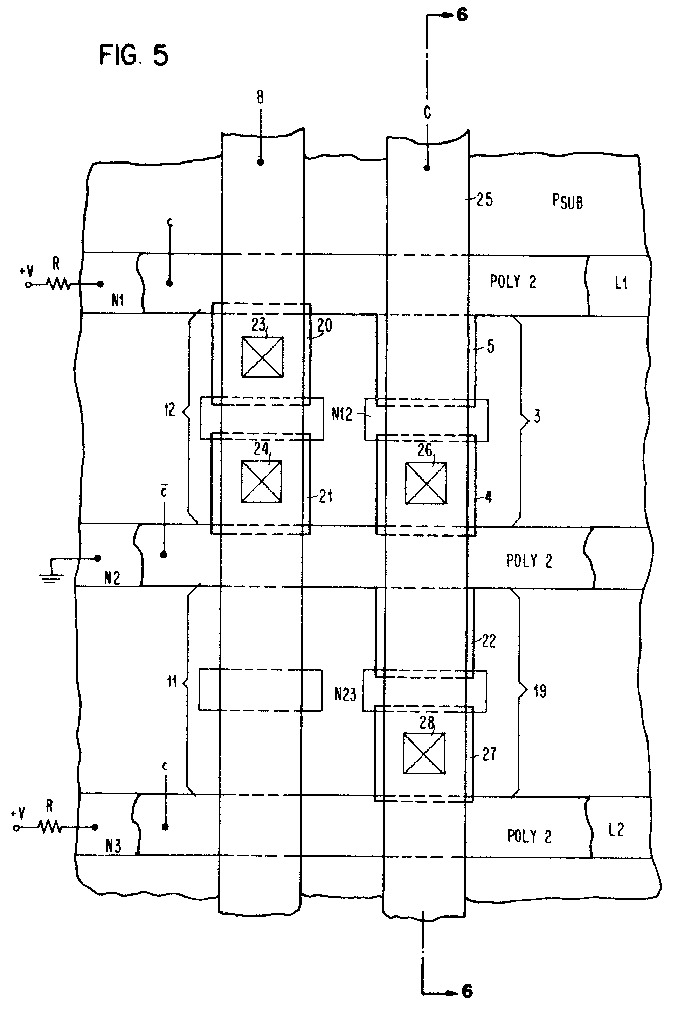

Im folgenden wird ein Ausführungsbeispiel der Erfindung für einen besonders flächensparenden integrierten Aufbau solcher Koppelelemente unter Ausnutzung eines sog. Doppelpolysilicium-Herstellungsprozesses an sich üblicher Art beschrieben. Die Fig. 5 und 6 zeigen dazu in einer Draufsicht und in einer Querschnittsdarstellung einen Ausschnitt aus einem PLA, der in dem Schaltbild von Fig. 4 die vier Kreuzungsstellen mit den Koppelelementen (FET) 12, 3, 11 und 19 sowie die Eingänge B und C umfaßt. Zur Erleichterung der Zuordnung sind dabei weitgehend die gleichen Bezugszeichen wie in Fig. 4 verwendet. Hinzuweisen ist noch darauf, daß es sich bei den Fig. 5 und 6 lediglich um schematische Darstellungen handelt und keineswegs um maßstabsgetreue Layouts.

In einem mit $P_{SUB}$ bezeichneten Halbleitersubstrat, z. B. aus Silicium, sind in für die MOSFET-Technologie üblicher Weise Source- und Drainzonen als Dotierungsstreifen N1, N2 und N3 vorgesehen. Für die als Drainzonen dienenden Dotierungsstreifen N1 und N3 ist schematisch über je einen Arbeitswiderstand R der Anschluß an die Betriebsspannung +V angedeutet. Die N1- und N2-Dotierungsstreifen bilden auf der anderen Seite die (Produktterm-)Leitungen L1 und L2. N2 dient für die Koppelelemente benachbarter Zeilen als gemeinsame Source und liegt beispielsweise an Masse. Da im gewählten Ausführungsbeispiel für jedes Koppelelement zwei Gate-Abschnitte vorgesehen sind, sind an den Nahtstellen der Gate-Abschnitte kanalunterstützende Dotierungsgebiete, z. B. N12 und N23 angedeutet.

Auf der Substratoberfläche sind unter benannter Vorsehung von Isolierschichten in bestimmten Mustern zwei Lagen aus (leitendem) polykristallinem Silicium, im folgenden Polysilicium genannt und in den Zeichnungen mit POLY 1 und POLY 2 bezeichnet, sowie eine Metallisierungsebene, z. B. aus Aluminium, gebildet. Mit der ersten Lage Polysilicium, POLY 1, wird je nach gewünschtem Zellenzustand des betreffenden Koppelelementes nur einer der beiden Gate-Abschnitte, z. B. 4 beim FET 3, oder ein komplettes Gate, wie z. B. beim FET 12 mit 2 verbundenen Gate-Hälften 20, 21 hergestellt. Mit der zweiten Lage Polysilicium, POLY 2, werden die c- und c̄-Steuerleitungen sowie die damit zu verbindende(n) Gate-Hälfte(n), z. B. 5 und 22, hergestellt. Quer zu den Dotierungsstreifen für N1, N2, N3 und den darüberliegenden Steuerleitungen c, c̄ (POLY 2) sind die Eingangsleitungen als Metallisierungsstreifen angeordnet. Dies ist in den Fig. 5 und 6 für die Eingänge B und C gezeigt. Es ist ersichtlich, daß der Eingang B über die mit 23, 24 bezeichneten Kontaktstellen im Bereich des FET 12 mit beiden Gate-Abschnitten 20, 21 verbunden ist. Für den Eingang C geht aus Fig. 5 und noch besser aus dem Querschnitt von Fig. 6 hervor, daß der zugehörige Leiterzug 25 mit dem Gate-Abschnitt 4 des FET 3 über den Kontakt 26 und mit dem Gate-Abschnitt 27 des FET 19 über den Kontakt 28 verbunden ist. An der Kreuzungsstelle B/L2 ist schließlich eine oben erläuterte sog. »Don't care«-Position dadurch festgelegt, daß die dort mit 11 angedeutete FET-Position durch Nichtausbilden der Gate- und zugehörigen Dünnoxid-Abschnitte nicht fertiggestellt ist. An dieser Stelle kann, vom Eingang B veranlaßt, in keinem der beiden angenommenen Funktionszuständen F1, F2 eine leitende Verbindung zwischen N3 und N2 zustandekommen.

Soweit für die Erläuterung der Erfindung als Ausführungsbeispiel der Aufbau eines PLA gewählt wurde, ist schließlich festzuhalten, daß die Erfindung gleichermaßen vorteilhaft auch auf dem Gebiet der normalen Festwertspeicher (ROM) Anwendung finden kann, die als Bestandteile von PLAs angesehen werden können, wie eingangs erläutert wurde. Ferner ist die Erfindung grundsätzlich nicht auf 2fach personalisierbare Festspeicher beschränkt. Es ist beispielsweise ersichtlich, daß eine 3fache Personalisierungsmöglichkeit durch Vorsehung dreier Gate-Abschnitte für die als Koppelelemente vewendeten FET erzielt werden kann. Weiterhin ist die Erfindung nicht auf die in den Ausführungsbeispielen zugrunde gelegten FET-Typen beschränkt, sondern es können bei Beachtung der entsprechend zu wählenden Betriebsspannungs- und Signalpolaritäten z. B. P-Kanal FET verwendet werden. In allgemeiner Hinsicht ist der der Erfindung zugrunde liegende Gedanke ferner nicht notwendig an die FET-Technologie gebunden. Er läßt sich auch in anderen heutigen Technologiearten verwirklichen, z. B. in der Bipolar-, der Josephson-, der GaAs-Technologie usw. Gleiches gilt für die Vereinbarung einer anders gewählten Zuordnung der Potentiale relativ zu den logischen Zuständen sowie hinsichtlich der im Ausführungsbeispiel zugrunde gelegten Materialien, z. B. Silicium, Polysilicium und Aluminium, für die es auf dem Gebiet der bekannten Halbleitertechnologie vielfältige Alternativen gibt.

**Patentansprüche**

1. Elektrisch umschaltbarer Festwertspeicher mit Koppelelementen, die an den Kreuzungsstellen einer Matrix-Anordnung je nach ihrem funktionsabhängigen Personalisierungszustand eine elektrisch leitende Verbindung bereitstellen oder nicht, dadurch gekennzeichnet, daß die Koppelelemente (3, 6, 7, 9, 11 bis 13, 15 bis 19) Feldeffekttransistoren (FET) mit mindestens zwei nebeneinander vorgesehenen Gate-Abschnitten sind, wobei ein Leitendwerden der zugehörigen Source-Drain-Schaltstrecke erst ermöglicht wird, wenn an allen Gate-Abschnitten die zugehörigen Einschalt-Potentiale vorliegen, und daß mindestens die beiden umschaltbaren Funktionen (F1, F2) in der Weise eingeprägt werden, daß bei einer nur im Rahmen einer (z. B. F1 oder F2) Funktion herzustellenden Verbindung einer der Gate-Abschnitte (z. B. 5 oder 22) mit der für die Funktionsauswahl maßgeblichen Steuerleitung (c oder c̄) und der verbleibende Gate-Abschnitt (z. B. 4, 27) bzw. die verbleibenden Gate-Abschnitte eines solchen Koppelelementes (z. B. 3, 19) mit der betreffenden Eingangsleitung (25) verbunden wird bzw. werden, und daß bei den im Rahmen mindestens der beiden Funktionen (F1 und F2) herzustellenden Verbindungen die jeweiligen Gate-Abschnitte (z. B. 10) eines solchen Koppelelementes (z. B. 9) gemeinsam an die betreffende Eingangsleitung (z. B. für A) angeschlossen sind.

2. Elektrisch umschaltbarer Festwertspeicher nach Anspruch 1, dadurch gekennzeichnet, daß mehrere solcher Speicherfelder (1, 2) zu PLA-Strukturen zusammengefaßt sind (Fig. 4).

3. Elektrisch umschaltbarer Festwertspeicher nach Anspruch 1 oder 2, dadurch gekennzeichnet, daß den Koppelelementen in benachbarten Reihen oder Spalten gemeinsame reihen- oder spaltenförmig verlaufende Steuer- oder Betriebsspannungsleitungen (z. B. c̄, Masse in Fig. 4) zugeordnet sind.

4. Elektrisch umschaltbarer Festwertspeicher nach mindestens einem der vorhergehenden Ansprüche, dadurch gekennzeichnet, daß die Koppelelemente aus integrierten FET-Strukturen aufgebaut sind, die im Kanalgebiet zwischen Source (N2) und Drain (N1, N3) unter den Nachtstellen zwischen benachbarten Gate-Abschnitten (z. B. 4, 5; 22, 27) die Kanalbildung unterstützende Dotierungsgebiete (N12, N23) aufweisen.

5. Elektrisch umschaltbarer Festwertspeicher nach mindestens einem der vorhergehenden Ansprüche, dadurch gekennzeichnet, daß die Gate-Abschnitte (z. B. 20, 21; 4, 5; 22, 27) der Koppelelemente (12, 3, 19) aus polykristallinem Silicium bestehen.

6. Elektrisch umschaltbarer Festwertspeicher nach mindestens einem der vorhergehenden Ansprüche, dadurch gekennzeichnet, daß die Steuerleitungen (c, c̄) für die Funktionsauswahl aus polykristallinem Silicium bestehen.

7. Elektrisch umschaltbarer Festwertspeicher nach Anspruch 6, dadurch gekennzeichnet, daß die die Steuerleitungen (c, c̄) darstellenden Polysiliciumstreifen (POLY 2) über den Dotierungsstreifen (N1, N2, N3) für Source und Drain der FET angeordnet sind.

8. Elektrisch umschaltbarer Festwertspeicher nach mindestens einem der Ansprüche 5 bis 7, dadurch gekennzeichnet, daß die mit den Eingängen (z. B. B, C in Fig. 5) gekoppelten Gate-Abschnitte (z. B. 20, 21, 4, 27) als erste Polysilicium-Lage (POLY 1) und die Steuerleitungen (c, c̄) sowie die damit gekoppelten Gate-Abschnitte (z. B. 5, 22) als zweite Polysilicium-Lage (POLY 2) ausgebildet sind.

9. Elektrisch umschaltbarer Festwertspeicher nach mindestens einem der vorhergehenden Ansprüche, dadurch gekennzeichnet, daß die mit den Eingängen (z. B. B, C in Fig. 5) gekoppelten Leitungen als Metall-Leiterzüge (z. B. 25) ausgebildet sind, die mit den zugehörigen Gate-Abschnitten (20, 21, 4, 27) aus Polysilicium (POLY 1) über Kontakte (23, 24, 26, 28) verbunden sind.

10. Verwendung eines elektrisch umschaltbaren Festwertspeichers nach mindestens einem der vorhergehenden Ansprüche in einem Prozessor-Baustein mit integrierten PLA-Funktionen, insbesondere zur Implementierung einer im Betrieb änderbaren Systemarchitektur, z. B. Doppelarchitektur.

## Claims

1. Electrically switchable read-only storage with coupling elements which at the crosspoints of a matrix arrangement, depending on their functional personalization mode do, or do not provide an electrically conductive connection, characterized in that the coupling elements (3, 6, 7, 9, 11 to 13, 15 to 19) are field effect transistors (FET's) with at least two adjacent gate sections, the associated source-drain circuit path becoming active under the contiditon that all gate sections are applied with the associated switching potentials, and that at least the two switchable functions (F1, F2) are personalized in such a manner that for a connection to be established in only one (e.g. F1 or F2) function one of ghe gate sections (e.g. 5 or 22) is connected to the control line (c or c̄) decisive for the selected function, and that the remaining gate section (e.g. 4, 27) or gate sections of such a coupling element (e.g. 3, 19) is or are connected to the respective input line (25), and that for the connections to be established in at least the two functions (F1 and F2) the respective gate sections (e.g. 10) of such a coupling element (e.g. 9) are jointly connected to the respective input line (e.g. for A).

2. Electrically switchable read-only storage as claimed in claim 1, characterized in that several such storage arrays (1, 2) are assembled into PLA structures (Fig. 4).

3. Electrically switchable read-only storage as claimed in claim 1 or 2, characterized in that the coupling elements have associated common row or column control or operating voltage lines (e.g. c̄, ground in Fig. 4) in adjacent rows or columns.

4. Electrically switchable read-only storage as claimed in at least one of the preceding claims, characterized of integrated FET structures which in the channel region between source (N2) and drain (N1, N3), beneath the boundaries between adjacent gate sections (e.g. 4, 5; 22, 27) show doping areas (N12, N23) supporting the channel formation.

5. Electrically switchable read-only storage as claimed in at least one of the preceding claims, characterized in that the gate sections (e.g. 20, 21; 4, 5; 22, 27) of the coupling elements (12, 3, 19) consist of polycrystalline silicon.

6. Electrically switchable read-only storage as claimed in at least one of the preceding claims, characterized in that the control lines (c, c̄) for the functional selection consist of polycrystalline silicon.

7. Electrically switchable read-only storage as claimed in claim 6, characterized in that the polysilicon strips (POLY 2) representing the control lines (c, c̄) are arranged over the doping strips (N1, N2, N3) for source and drain of the FET's.

8. Electrically switchable read-only storage as claimed in at least one of claims 5 to 7, characterized in that the gate sections (e.g. 20, 21, 4, 27) coupled to the inputs (e.g. B, C in Fig. 5) are designed as a first polysilicon layer (POLY 1), and the control lines (c, c̄) as well as the gate sections (e.g. 5, 22) coupled thereto are designed as a second polysilicon layer (POLY 2).

9. Electrically switchable read-only storage as claimed in at least one of the preceding claims characterized in that the lines coupled to the inputs (e.g. B, C in Fig. 5) are designed as metal wire lines (e.g. 25) which with the associated gate sections (20, 21, 4, 27) of polysilicon (POLY 1) are connected via contacts (23, 24, 26, 28).

10. Use of an electrically switchable read-only storage as claimed in at least one of the preceding claims, in a processor component with integrated PLA functions, particularly for implementing a system architecture alterable in operation, e.g. double architecture.

## Revendications

1. Mémoire morte électriquement commutable comportant des éléments de couplage qui conditionnent, selon l'état fonctionnel individuel qui leur est respectivement attribué, une connexion électriquement conductrice aux jonctions dans une matrice, caractérisé en ce que lesdits éléments de couplage (3, 6, 7, 9, 11 à 13, 15 à 19) sont des transistors à effet de champ comportant au moins deux parties de porte montées de façon contigüe, où le chemin de connexion Source-Drain correspondant ne passe à l'état conducteur que lorsque toutes les parties de porte reçoivent les tensions appropriées, en ce que des tensions sont appliquées au moins aux deux fonctions commutables (F1, F2) de manière à ce que, et ceci dans le cas où une connexion doit être établie dans une desdites fonctions seulement (par exemple F1 ou F2), und des parties de porte (par exemple la partie 5 ou 22) soit connectée avec la ligne de commande (c ou c̄) correspondant à la sélection de la fonction et l'autre partie de porte (par exemple 4, 27) ou les autres parties de porte d'un élément de couplage de ce type (par exemple 3, 19) soit (ent) connectée (s) avec la ligne d'entrée (25) correspondant et, en ce que, dans le cas où des connexions sont à établir dans au moins les deux dites fonction (F1 et F2), les parties de porte respectives (par exemple 10) soient connectées en commun avec la ligne d'entrée correspondante (par exemple A).

2. Mémoire morte électriquement commutable selon la revendication 1, caractérisé en ce que plusieurs champs de mémoire de ce type (1, 2) sont assemblées pour former des réseaux logiques programmables (figure 4).

3. Mémoire morte électriquement commutable selon la revendication 1 ou 2, caractérisé en ce que des lignes de commande ou d'alimentation de tension d'alimentation (par exemple c, tension à la masse, figure 4), disposées ensemble en rang ou en colonne, sont associées auxdits éléments de couplage situés dans des rangs ou des colonnes contigües.

4. Mémoire morte électriquement commutable selon au moins des revendications précédentes, caractérisé en ce que lesdits éléments de couplage sont constitués de structures de transistors à effet de champ intégrés qui comportent dans la zone de canal entre la source (N2) et le Drain (N1, N3) et sous les jonctions entre les parties de porte voisines (par exemple 4, 5; 22, 27), des régions de dopage (N12, N23) qui contribuent à la formation du canal.

5. Mémoire morte électriquement commutable selon au moins une des revendications précédentes, caractérisé en ce que lesdites parties de porte (par exemple 20, 21; 4, 5; 22, 27) desdits éléments de couplage (12, 3, 9) sont composées de silicium polycristallin.

6. Mémoire morte électriquement commutable selon au moins une des revendications précédentes, caractérisé en ce que lesdites lignes de commande (c, c̄) permettant la sélection de fonction sont composées de silicium polycristallin.

7. Mémoire morte électriquement commutable selon la revendication 6, caractérisé en ce que les bandes de silicium (poly 2) représentant lesdites lignes de commande (c, c̄) sont disposées au-dessus des bandes de dopage (N1, N2, N3) des Source et Drain des transistors à effet de champ.

8. Mémoire morte électriquement commutable selon au moins une des revendications 5 à 7, caractérisé en ce que lesdites parties de porte (par exemple 20, 21, 4, 27) connectées auxdites entrées (par exemple B, C, figure 5) sont réalisées sous la forme d'une première couche de polysilicium (poly 1) et lesdites lignes de commande (c, c̄) et les parties de porte que leur sont connectées (par exemple 5, 22) sont réalisées sous la forme d'une seconde couche de polysilicium (Poly 2).

9. Mémoire morte électriquement commutable selon au moins une des revendications précédentes, caractérisé en ce que les lignes connectées avec lesdites entrées (par exemple B, C figure 5) sont réalisées comme conducteurs métalliques (par exemple 25) qui sont connectées par des contacts (23, 24, 26, 28) avec lesdites parties de porte associées (20, 21, 4, 27) en polysilicium (Poly 1).

10. Utilisation d'une mémoire morte électriquement commutable selon au moins une des revendications précédentes dans un composant de processeur comportant des fonctions intégrées de circuits logiques programmables, en particulier pour mettre en oeuvre une architecture de système modifiable sans interruption, par exemple une architecture double.

**FIG. 1**

$$F1 \cdot X = \overline{A} \cdot \overline{B} \cdot \overline{C} + \overline{D}$$
$$Y = \overline{A} \cdot B \cdot \overline{C}$$

**FIG. 2**

$$F2 : X = \overline{A} \cdot \overline{B} \cdot \overline{D} + \overline{A} \cdot \overline{C}$$
$$Y = \overline{A} \cdot \overline{C}$$

**FIG. 3**

$$F1 \longrightarrow \quad c = 1$$
$$\overline{c} = 0$$
$$F2 \longrightarrow \quad c = 0$$
$$\overline{c} = 1$$

FIG. 4

FIG. 6

FIG. 5